# EUROPÄISCHE PATENTSCHRIFT

(11) **EP 3 186 650 B1**
(45) Veröffentlichungstag und Bekanntmachung des Hinweises auf die Patenterteilung: **26.09.2018**
(21) Anmeldenummer: 15734174.4
(22) Anmeldetag: 06.07.2015
(51) Int. Cl.: G01R 31/36

(54) **VERFAHREN ZUR BESTIMMUNG EINES INNENWIDERSTANDS EINES ELEKTRISCHEN ENERGIESPEICHERS**
METHOD FOR DETERMINING AN INTERNAL RESISTANCE OF AN ELECTRICAL ENERGY ACCUMULATOR
PROCÉDÉ DE DÉTERMINATION DE LA RÉSISTANCE INTERNE D'UN ACCUMULATEUR D'ÉNERGIE ÉLECTRIQUE

(30) Priorität: 27.08.2014 DE 102014217087
(43) Veröffentlichungstag der Anmeldung: 05.07.2017
(73) Patentinhaber: Robert Bosch GmbH, 70442 Stuttgart (DE)
(72) Erfinder: VARADI, Ferenc, 2230 Gyömrö (HU); BARANY, Gabor, 1083 Budapest (HU); STOLCZENBERGER, Robert, 8060 Mor (HU)
(86) Internationale Anmeldenummer: PCT/EP2015/065336
(87) Internationale Veröffentlichungsnummer: WO 2016/030065

(56) Entgegenhaltungen:
- EP-A2- 1 522 866
- DE-A1-102010 043 388
- US-A1- 2012 303 301

## Beschreibung

### Stand der Technik

Der Innenwiderstand eines Energiespeichers kann auf verschiedene Weisen bestimmt werden. Im Fahrzeugbereich werden üblicherweise der differentielle Widerstand, der Nullphasen-Widerstand oder der ohmsche Widerstand berechnet und hieraus der Innenwiderstand bestimmt. Eine Methode zur Bestimmung des Innenwiderstands mittels der Berechnung des differentiellen Widerstands ist in der Offenlegungsschrift WO 2006037694 A1 offenbart.

Weiterer Stand der Technik findet sich in den Offenlegungsschriften EP1522866 und US2012303301.

### Offenbarung der Erfindung

Die Erfindung betrifft ein Verfahren zur Bestimmung eines Innenwiderstands eines elektrischen Energiespeichers. Erfindungsgemäß wird der Innenwiderstand bestimmt, indem ein Nullphasen-Widerstand berechnet wird, welcher wiederum als zu bestimmender Innenwiderstand bereitgestellt wird. Hierbei laufen folgende Verfahrensschritte nacheinander ab:
a. Analog/Digital-Wandeln eines analogen Spannungssignals und eines analogen Stromsignals des elektrischen Energiespeichers, um digitale Spannungswerte und digitale Stromwerte zu erhalten,
b. Filtern der digitalen Spannungswerte und der digitalen Stromwerte mit einem Bandpassfilter um die Nullphasen-Frequenz herum, um gefilterte Spannungswerte und Stromwerte zu erhalten,
c. Prüfen ob folgende Berechnungsvoraussetzungen erfüllt sind:
   I. Der Bandpassfilter ist initialisiert,
   II. ein Stromspitzenwert mit seinem zugehörigen Zeitpunkt wird aus den gefilterten Stromwerten ermittelt,
   III. der Betrag des Stromspitzenwertes ist größer als der Betrag eines Schwellenstromwerts, wobei der Betrag des Schwellenstromwert größer als der Betrag eines minimalen Schwellenstromwerts ist, mit welchem ein Nullphasen-Widerstand mit einer vorgegebenen maximalen Abweichung vom tatsächlichen Innendwiderstand berechnet werden kann,
   IV. der gefilterter Spannungswert zum zuvor ermittelten Zeitpunkt ist ein Spannungsspitzenwert,
   V. der Stromspitzenwert und der Spannungsspitzenwert haben das gleiche Vorzeichen,
   wobei diese Berechnungsvoraussetzungen nacheinander geprüft werden, jedoch die Berechnungsvoraussetzung I auch an einer beliebigen anderen Stelle im Verfahrensschritt c geprüft werden kann, und wobei das Verfahren beendet wird, falls eine der Berechnungsvoraussetzungen nicht erfüllt ist,
d. Berechnen des Nullphasen-Widerstands aus dem Spannungsspitzenwert und dem Stromspitzenwert, falls das Verfahren zuvor noch nicht beendet wurde,
e. Bereitstellen des Nullphasenwiderstands als zu bestimmender Innenwiderstand des elektrischen Energiespeichers, falls das Verfahren zuvor noch nicht beendet wurde.

Vorteilhaft ist hierbei, dass bereits kleine Strom- bzw. Spannungsschwankungen als Anregung für den elektrischen Energiespeicher zur Berechnung des Nullphasen-Widerstands und somit zur Bestimmung des Innenwiderstands des elektrischen Energiespeichers ausreichen, wie dies beispielsweise während der Fahrt oder bei ausgeschaltetem Motor der Fall ist. Eine starke Anregung des elektrischen Energiespeichers auf Grund eines Motorstarts ist daher keine Voraussetzung mehr, um den Innenwiderstand bestimmen zu können. Dies ist insbesondere bei Hybrid- und Elektrofahrzeugen von Vorteil, die keinen klassischen Motorstart aufweisen. Zudem benötigt das Verfahren nur einen geringen Berechnungsaufwand im Vergleich zu anderen Verfahren zur Innenwiderstandsbestimmung, beispielsweise einem Verfahren mittels Spektralmethode bei welchem der Innenwiderstand durch diskrete FourierTransformation bestimmt wird. Das Verfahren ist außerdem für die Benutzung in einem eingebetteten System optimiert, beispielsweise in einem elektrischen Batteriesensor, und kann sowohl für aktive als auch für passive Bestimmung des Innenwiderstands eingesetzt werden. Eine aktive Bestimmung bezeichnet hierbei die Anregung des elektrischen Energiespeichers mit einer kontrollierten Wechselspannung bei spezifischen Frequenzen. Der Hauptvorteil liegt darin, dass der Innenwiderstand durchgehend und unabhängig von der Netzspannung berechnet werden kann. Jedoch benötigt die aktive Bestimmung eine komplexe Hardware mit Leistungselektronik und belastet zudem die Batterie. Eine passive Bestimmung bezeichnet dagegen die Anregung des elektrischen Energiespeichers durch eine Netzspannung eines Drehstromgenerators oder durch einen Verbraucher. Die Hardware-Anforderungen sind hierdurch geringer, da nur eine Messung des Stroms und der Spannung des Energiespeichers nötig sind. Dies kann beispielsweise durch einen Shunt oder einen Hallsensor umgesetzt werden. Da bei dieser passiven Bestimmung jedoch die Anregung des Energiespeichers nicht direkt kontrolliert wird, wird der Innenwiderstand nicht aktualisiert, falls die Berechnungsvoraussetzungen nicht erfüllt werden. Des Weiteren kann durch das Verändern des Schwellenstromwerts, die Genauigkeit der Bestimmung des Innenwiderstands eingestellt werden.

Eine vorteilhafte Ausgestaltung des erfindungsgemäßen Verfahrens sieht vor, dass zwischen dem Verfahrensschritt a und dem Verfahrensschritt e ein weiterer Verfahrensschritt f abläuft, in welchem die Gültigkeit der digitalen Spannungswerte und der digitalen Stromwerte überprüft wird. Hierbei gelten die digitalen Spannungswerte und digitalen Stromwerte als gültig, falls der Verfahrensschritt a erfolgreich durchgeführt wurde. Bei einem ungültigen digitalen Spannungswert oder digitalen Stromwert wird dagegen das Verfahren beendet. Vorteilhaft ist hierbei, dass das Verfahren nur mit gültigen, das bedeutet fehlerfreien, Messwerten weitergeführt wird. Hierdurch kann bei fehlerhaften Messwerten zum einen der Berechnungsaufwand reduziert werden und zum anderen kann vermieden werden, dass ein fehlerhafter Nullphasen-Widerstand als Innenwiderstand bereitgestellt wird.

Eine weitere vorteilhafte Ausgestaltung des erfindungsgemäßen Verfahrens sieht vor, dass der Stromspitzenwert oder auch der Spannungsspitzenwert mittels eines, insbesondere drei-elementigen, First In - First Out-Prinzips (FIFO) ermittelt werden. Vorteilhaft ist hierbei, dass das FIFO-Prinzip ein einfaches Mittel darstellt, um einen Spitzenwert aus mehreren Werten zu ermitteln. Hierdurch wird die für diesen Verfahrensschritt benötigte Rechenleistung gering gehalten.

In einer vorteilhaften Ausgestaltung des erfindungsgemäßen Verfahrens ist vorgesehen, dass zwischen dem Verfahrensschritt d und dem Verfahrensschritt e ein weiterer Verfahrensschritt g abläuft, in welchem die Plausibilität des Nullphasen-Widerstands geprüft wird. Hierbei gilt der Nullphasen-Widerstand als plausibel, falls er zwischen einem theoretischen Minimal-Grenzwert und einem theoretischen Maximal-Grenzwert des zu erwartenden Innenwiderstands liegt. Ist dies nicht der Fall, wird das Verfahren beendet. Vorteilhaft ist hierbei, dass der berechnete Nullphasen-Widerstand nur dann im Verfahrensschritt e als Innenwiderstand bereitgestellt wird, falls er als plausibel eingestuft ist. Hierdurch kann das Bereitstellen eines fehlerhaften Nullphasen-Widerstands als Innenwiderstand vermieden werden.

In einer weiteren vorteilhaften Ausgestaltung des erfindungsgemäßen Verfahrens ist vorgesehen, dass das Berechnen des Nullphasen-Widerstands im Verfahrensschritt d durch Bildung eines Quotienten aus Spannungsspitzenwert und Stromspitzenwert erfolgt. Vorteilhaft ist hierbei, dass dies eine einfache Möglichkeit zur Berechnung des Nullphasen-Widerstands darstellt und somit nur eine geringe Rechenkapazität erfordert.

Eine vorteilhafte Ausführungsform des erfindungsgemäßen Verfahrens sieht vor, dass zwischen dem Verfahrensschritt d und dem Verfahrensschritt e ein weiterer Verfahrensschritt h abläuft, in welchem der berechnete Nullphasen-Widerstand tiefpassgefiltert wird, insbesondere mittels eines PT1-Glieds. Vorteilhaft ist hierbei, dass durch die Filterung die Standardabweichung reduziert werden kann, welche beispielsweise auf Grund von Messrauschen auftritt.

Eine weitere vorteilhafte Ausgestaltung des erfindungsgemäßen Verfahrens sieht vor, dass das Berechnen des Nullphasen-Widerstands im Verfahrensschritt d durch Bildung eines Quotienten des quadratischen Mittels der Spannungsspitzenwerte zum quadratischen Mittel der Stromspitzenwerte erfolgt. Vorteilhaft ist hierbei, dass die Genauigkeit bei der Berechnung des Nullphasen-Widerstands durch diese Berechnungsweise nochmals gesteigert wird.

### Zeichnungen

Fig. 1 zeigt ein erstes Ausführungsbeispiel eines erfindungsgemäßen Verfahrens zur Bestimmung des Innenwiderstands eines elektrischen Energiespeichers.
Fig. 2 zeigt ein zweites Ausführungsbeispiel eines erfindungsgemäßen Verfahrens zur Bestimmung des Innenwiderstands eines elektrischen Energiespeichers.
Fig. 3 zeigt ein drittes Ausführungsbeispiel eines erfindungsgemäßen Verfahrens zur Bestimmung des Innenwiderstands eines elektrischen Energiespeichers.
Fig. 4 zeigt ein viertes Ausführungsbeispiel eines erfindungsgemäßen Verfahrens zur Bestimmung des Innenwiderstands eines elektrischen Energiespeichers.

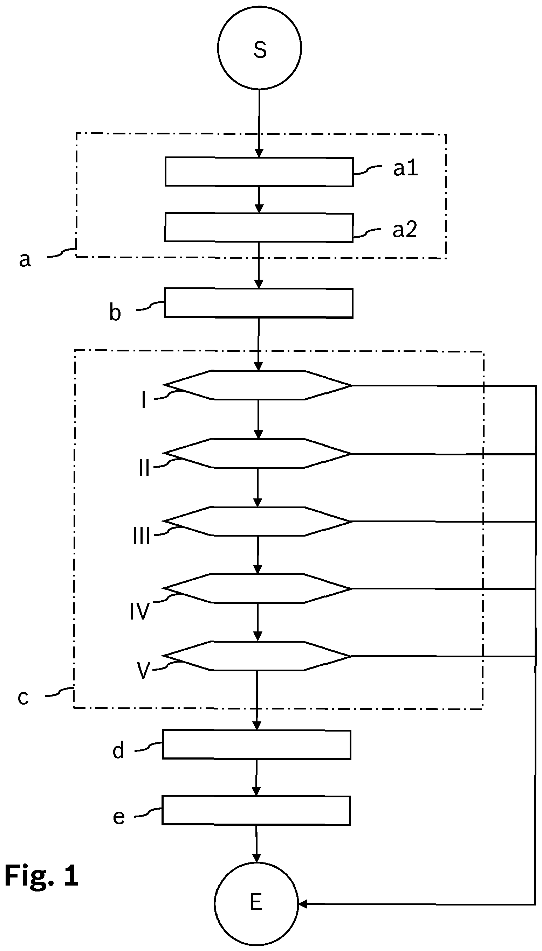

Fig. 1 zeigt ein erstes Ausführungsbeispiel eines erfindungsgemäßen Verfahrens zur Bestimmung des Innenwiderstands eines elektrischen Energiespeichers. Das Verfahren beginnt im Start S. Zuerst werden in einem Verfahrensschritt a ein analoges Spannungssignal U_{analog} und ein analoges Stromsignal I_{analog} des elektrischen Energiespeichers in digitale Spannungswerte U und digitale Stromwerte I umgewandelt. Diese Analog/Digital-Wandlung geschieht im Verfahrensschritt a durch einen ersten Teilschritt a1 und einen zweiten Teilschritt a2. Im ersten Teilschritt a1 werden das analoge Spannungssignal U_{analog} und das analoge Stromsignal I_{analog} tiefpassgefiltert, wobei dies beispielsweise mittels einen analogen Tiefpassfilters geschieht. Daraufhin wird im zweiten Teilschritt a2 das tiefpassgefilterte analoge Spannungssignal U_{analog} und das tiefpassgefilterte analoge Stromsignal I_{analog} abgetastet, um digitale Spannungswerte U und digitale Stromwerte I zu erhalten. Hierbei erfolgt das Abtasten für das analoge Spannungssignal U_{analog} und das analoge Stromsignal I_{analog} synchron und unter der Voraussetzung, dass eine Abtastfrequenz f_{Tast} mindestens doppelt so groß wie eine maximale Nullphasenfrequenz f_{zp, max} ist. Die Tiefpassfilterung dient dabei dazu, dass die Bandbreite des abzutastenden Signals der Abtastrate genügt. Des Weiteren wird durch die Voraussetzung für die Abtastfrequenz f_{Tast} das Nyquist-Shannon-Abtasttheorem eingehalten. Die digitalen Spannungswerte U und die digitalen Stromwerte I werden in einem anschließenden Verfahrensschritt b gefiltert. Die Filterung geschieht hierbei mittels eines Bandpassfilters, welcher um eine Nullphasen-Frequenz f_{zp} herum filtert. Bei dieser Nullphasen-Frequenz f_{zp} ist der Impedanzwinkel in etwa null. Die Nullphasen-Frequenz f_{zp} ist beispielsweise abhängig von der Art des Energiespeichers, der Temperatur und des Ladungszustands. Bei Bleibatterien liegt die Nullphasen-Frequenz f_{zp} typscherweise zwischen 300Hz und 1kHz. Durch die Bandpassfilterung erhält man gefilterte Spannungswerte U_{filt} und gefilterte Stromwerte I_{filt}. In einem weiteren Verfahrensschritt c werden anschließend mehrere Berechnungsvoraussetzungen nacheinander geprüft. Sobald auch nur eine dieser Berechnungsvoraussetzungen nicht erfüllt ist, wird das Verfahren vorzeitig beendet. Das Beenden ist hierbei als Ende E dargestellt. Das Verfahren beginnt typischerweise nach dem Beenden wieder im Start S. Anhand der Berechnungsvoraussetzung I wird geprüft, ob der Bandpassfilter initialisiert ist. So ist beispielsweise bei einem Bandpassfilter n-ter Ordnung der Bandpassfilter erst nach n abgetasteten Werten initialisiert, wobei n hier eine natürliche Zahl, größer Null, darstellt. Durch die Berechnungsvoraussetzung II wird geprüft, ob ein Stromspitzenwert Iₚ aus den gefilterten Stromwerten I_{filt} ermittelt werden kann. Der Stromspitzenwert Iₚ wird beispielsweise mittels eines, insbesondere drei-elementigen, FIFO-Prinzips ermittelt. Hierbei werden die zuletzt abgetasteten und anschließend gefilterten Stromwerte I_{filt} miteinander verglichen. Kann hierbei einer der gefilterten Stromwerte I_{filt} als Stromspitzenwert Iₚ ausgemacht werden, wird das zeitliche Auftreten des Stromspitzenwerts Iₚ als Zeitpunkt tₚ definiert. Wird dagegen kein Stromspitzenwert Iₚ ermittelt, wird beim nächsten Verfahrensdurchlauf wenigstens ein ältester, gefilterte Stromwert I_{filt} durch wenigstens einen neuen, gefilterten Stromwert I_{filt} ersetzt und versucht, aus den vorhandenen und neuen Werten ein Stromspitzenwert Iₚ zu ermitteln. Als dritte Berechnungsvoraussetzung III wird geprüft, ob der Betrag des Stromspitzenwerts Iₚ größer als der Betrag eines Schwellenstromwerts Iₜₕ ist. Hierbei kann der Schwellenstromwert Iₜₕ von Verfahrensdurchlauf zu Verfahrensdurchlauf verändert werden, vorausgesetzt, dass dessen Betrag stets größer als der Betrag eines minimalen Schwellenstromwerts I_{th, min} ist, mit welchem ein Nullphasen-Widerstand R_{zp} noch mit einer vorgegebenen, maximalen Abweichung vom tatsächlichen Innenwiderstands Rᵢ des elektrischen Energiespeichers berechnet werden kann. So sollte beispielsweise die maximale Abweichung zwischen dem mittels eines Batteriesensors bestimmten Innenwiderstand Rᵢ und einem tatsächlichen Ist-Wert des Innendwiderstands Rᵢ nicht größer als 10% sein. Durch die Veränderung des Schwellenstromwerts Iₜₕ kann die Genauigkeit der Berechnung Nullphasen-Widerstands R_{zp} auf Kosten der Häufigkeit von dessen Berechnung angepasst werden. Hierbei gilt, je höher der Schwellenstrom Iₜₕ, desto genauer der berechnete Nullphasen-Widerstands R_{zp} und somit auch der bereitgestellte Innenwiderstand Rᵢ, jedoch desto seltener die Nullphasen-Widerstands-Berechnung an sich. Anschließend wird mittels der Berechnungsvoraussetzung IV geprüft, ob der gefilterte Spannungswert U_{filt} zum Zeitpunkt tₚ ein Spannungsspitzenwert Uₚ ist. Dies wird beispielsweise wiederum mittels eines FIFO-Prinzips umgesetzt. Abschließend wird dann mit der Berechnungsvoraussetzung V geprüft, ob der Stromspitzenwert Iₚ und der Spannungsspitzenwert Uₚ das gleiche Vorzeichen haben. Durch die Berechnungsvoraussetzungen und die Bandpassfilterung wird erreicht, dass sowohl der Stromspitzenwert Iₚ als auch das Spannungsspitzenwert Uₚ im Wesentlichen aus einem Realteil bestehen und somit keinen bzw. nur einen sehr geringen Imaginärteil aufweisen. Dies bedeutet, dass die Phasenwinkel des abgetasteten analogen Strom- und des Spannungssignals entweder etwa 0° oder etwa 180° betragen. Hierdurch kann in einem anschließenden Verfahrensschritt d ein Nullphasen-Widerstand R_{zp} als Maß für den Innenwiderstand Rᵢ berechnet werden. Die Berechnung des Nullphasen-Widerstands R_{zp} erfolgt dabei, indem der Spannungsspitzenwert Uₚ durch den Stromspitzenwert I_{P} geteilt wird. Anschließend wird in einem Verfahrensschritt e der berechnete Nullphasen-Widerstands R_{zp} als zu bestimmender Innendwiderstand Rᵢ bereitgestellt und abschließend das Verfahren beendet. Nach dem Ende E wird das Verfahren, wie bereits erwähnt, typischerweise wieder neugestartet. Dies geschieht so lange, bis der Innenwiderstand Rᵢ nicht mehr bestimmt soll. Zudem laufen im Normalfall mehrere dieser Verfahren zeitversetzt ab. So wird beispielsweise das analoge Spannungssignal U_{analog} und das analoge Stromsignal I_{analog} über eine bestimmte Dauer hinweg abgetastet und daraus im weiteren Verlauf des Verfahrens versucht, den Innenwiderstand Rᵢ des Energiespeichers zu bestimmen, indem die Werte wie aufgezeigt weiterverarbeitet werden. Während dieser Weiterverarbeitung wird das Verfahren jedoch bereits erneut gestartet um das analoge Spannungssignal U_{analog} und das analoge Stromsignal I_{analog} auch weiterhin abzutasten und daraus wiederum den Innenwiderstand Rᵢ zu bestimmen.

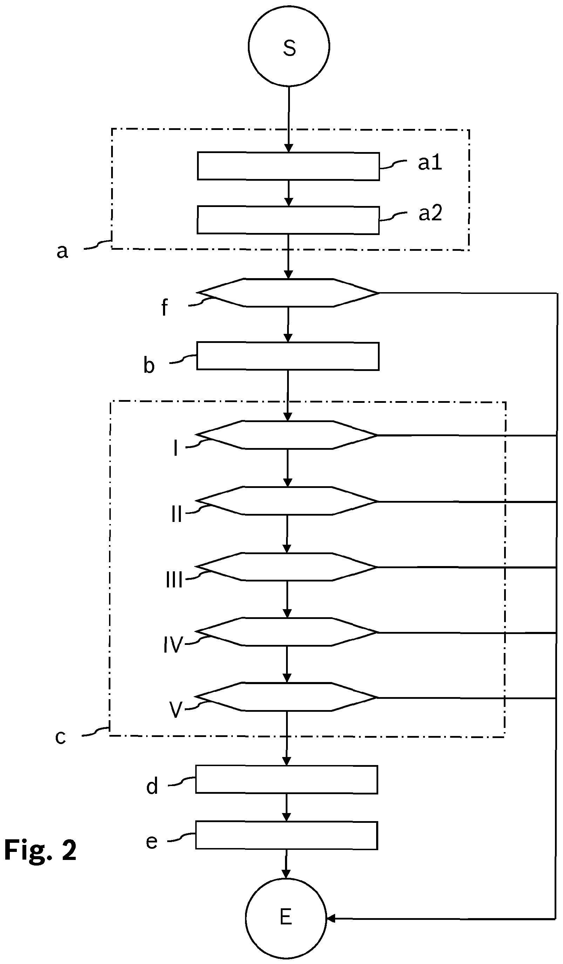

Fig. 2 zeigt ein zweites Ausführungsbeispiel eines erfindungsgemäßen Verfahrens zur Bestimmung des Innenwiderstands eines elektrischen Energiespeichers. Das Verfahren läuft dabei identisch zu dem Verfahren nach Fig. 1 ab. Allerdings wird zwischen dem Verfahrensschritt a und dem Verfahrensschritt b ein optionaler Verfahrensschritt f durchgeführt, in welchem geprüft wird, ob die Analog/Digital-Wandlung im Verfahrensschritt a erfolgreich durchgeführt wurde. Ist dies nicht der Fall, gelten die digitalen Spannungswerte U bzw. digitalen Stromwerte I als ungültig und das Verfahren wird beendet. Mögliche Gründe für eine fehlerhafte A/D-Wandlung sind beispielsweise auftretende Störsignale oder eine Neukonfiguration des A/D-Wandlers. Umgesetzt kann die Plausibilitätsprüfung beispielsweise, indem die digitalen Spannungswerte U und die digitalen Stromwerte I bei der A/D-Wandlung einen zusätzlichen, binären Status-Flag erhalten, welcher aussagt, ob die A/D-Wandlung erfolgreich war. Daraufhin muss im Verfahrensschritt f nur noch geprüft werden, ob der Status-Flag des jeweiligen Wertes gesetzt ist oder nicht.

In einem alternativen, bildlich nicht dargestellten Ausführungsbeispiel wird der Verfahrensschritt f nach dem Verfahrensschritt b, aber zumindest vor dem Verfahrensschritt e durchgeführt. In einem weiteren, nicht bildlich dargestellten Ausführungsbeispiel wird bei Beenden des Verfahrens auf Grund eines ungültigen, digitalen Stromwerts I oder auch eines ungültigen, digitalen Spannungswerts U der A/D-Wandler und der Tiefpassfilter reinitialisiert, bevor das Verfahren das nächste Mal gestartet wird.

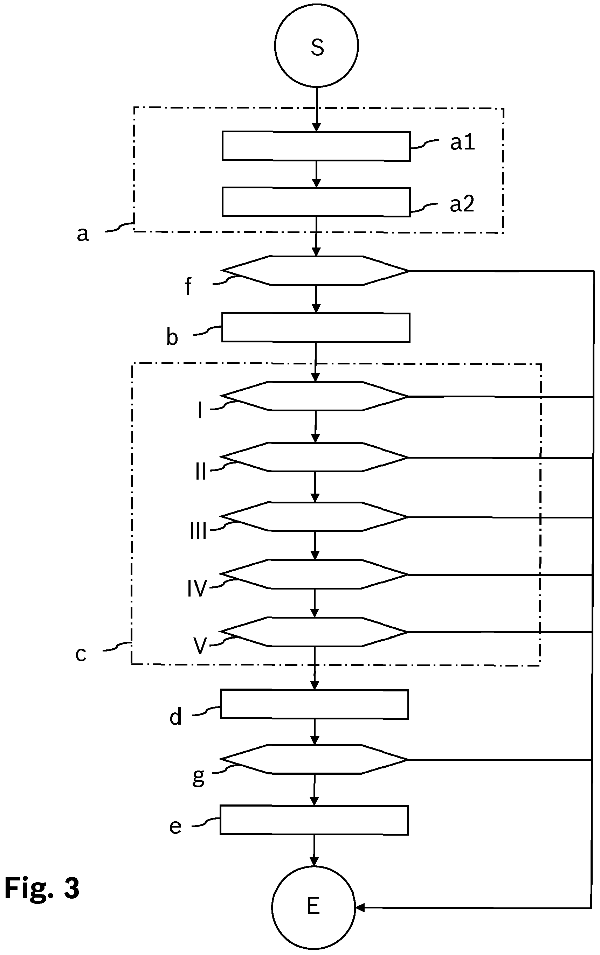

Fig. 3 zeigt ein drittes Ausführungsbeispiel eines erfindungsgemäßen Verfahrens zur Bestimmung des Innenwiderstands eines elektrischen Energiespeichers. Das Ausführungsbeispiel weist ausgehend von dem Verfahren nach Fig. 2 einen weiteren, optionalen Verfahrensschritt g auf. Dieser Verfahrensschritt g wird zwischen dem Verfahrensschritt d und vor dem Verfahrensschritt e durchgeführt. Im Verfahrensschritt g wird dabei geprüft, ob der berechnete Nullphasen-Widerstands R_{zp} zwischen einem theoretischen Minimal-Grenzwert R_{i, min} und einem theoretischen Maximal-Grenzwert R_{i, max} liegt. Ist dies nicht der Fall, wird das Verfahren wiederum vorzeitig beendet. Für Bleibatterien beispielsweise liegen der Minimal-Grenzwert R_{i, min} bei etwa 2mΩ und der Maximal-Grenzwert R_{i, max} bei etwa 50mΩ.

In einem nicht dargestellten, alternativen Ausführungsbeispiel verläuft das Verfahren identisch zu einem der in den Figuren 1, 2 oder 3 aufgezeigten Ausführungsbeispiele. Lediglich im Verfahrensschritt d unterscheidet sich dieses alternative Ausführungsbeispiel. So wird hierbei der Nullphasen-Widerstands R_{zp} im Verfahrensschritt d berechnet, indem das quadratische Mittel der Spannungsspitzenwerte Uₚ durch das quadratische Mittel der Stromspitzenwerte Iₚ geteilt wird.

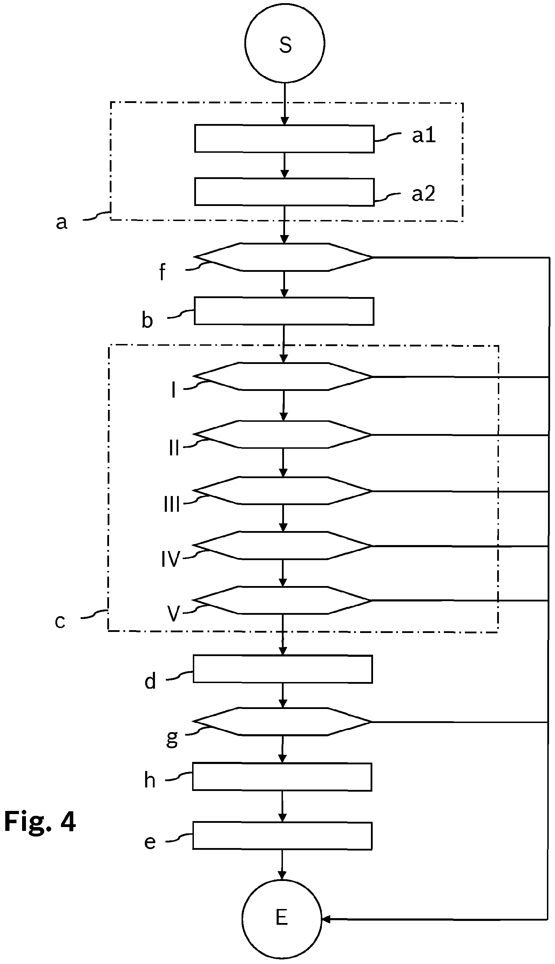

Fig. 4 zeigt ein viertes Ausführungsbeispiel eines erfindungsgemäßen Verfahrens zur Bestimmung des Innenwiderstands eines elektrischen Energiespeichers. Das Verfahren weist ausgehend von dem Verfahren nach Fig. 3 einen weiteren, optionalen Verfahrensschritt h auf. Der Verfahrensschritt h wird nach dem Verfahrensschritt d, aber vor dem Verfahrensschritt e durchgeführt. Allerdings nur für den Fall, dass der Nullphasen-Widerstands R_{zp} im Verfahrensschritt d durch die Bildung eines Quotienten aus dem Spannungsspitzenwert Uₚ und dem Stromspitzenwert Iₚ berechnet wurde. Im Verfahrensschritt h wird der berechnete Nullphasen-Widerstands R_{zp} tiefpassgefiltert, wobei dies beispielsweise mittels eines PT1-Glieds funktioniert.

In weiteren, alternativen, nicht bildlich dargestellten Ausführungsbeispielen können die optionalen Verfahrensschritte f, g und h auch unabhängig voneinander in einem Verfahren ablaufen. So ist es beispielsweise möglich, dass ausgehend vom Verfahren nach Fig. 1 nur der Verfahrensschritt g zwischen dem Verfahrensschritt d und dem Verfahrensschritt e abläuft, die Verfahrensschritte f und h jedoch nicht durchgeführt werden.

In den zuvor genannten Ausführungsbeispielen wird der Innenwiderstand Rᵢ bestimmt, indem der Nullphasen-Widerstands R_{zp} berechnet wird. Anhand des berechneten Nullphasen-Widerstands R_{zp} lassen sich allerdings auch weitere Widerstands-Definitionen, wie beispielsweise ein differentieller Widerstand, ein 1-kHz-Widerstand oder ein ohmscher Widerstand, näherungsweise bestimmen. Dies liegt darin begründet, dass die Abweichungen zwischen all diesen Widerstands-Definitionen in einem gewissen Maße begrenzt sind. Daher kann beispielsweise aus dem berechneten Nullphasen-Widerstand R_{zp} auch der differentielle Widerstand mit einer gewissen Toleranz bestimmt werden.

## Patentansprüche

1. Verfahren zur Bestimmung eines Innenwiderstands (Rᵢ) eines elektrischen Energiespeichers mit folgenden, nacheinander ablaufenden Verfahrensschritten:
a. Analog-Digital-Wandeln eines analogen Spannungssignals (U_{analog}) und eines analogen Stromsignals (I_{analog}) des elektrischen Energiespeichers, um digitale Spannungswerte (U) und digitale Stromwerte (I) zu erhalten,
b. Filtern der digitalen Spannungswerte (U) und der digitalen Stromwerte (I) mit einem Bandpassfilter um die Nullphasen-Frequenz (f_{zp}) herum, um gefilterte Spannungswerte (U_{filt}) und Stromwerte (I_{filt}) zu erhalten,
c. Prüfen ob folgende Berechnungsvoraussetzungen erfüllt sind:
I. Der Bandpassfilter ist initialisiert,
II. ein Stromspitzenwert (Iₚ) mit seinem zugehörigen Zeitpunkt (tₚ) wird aus den gefilterten Stromwerten (I_{filt}) ermittelt,
III. der Betrag des Stromspitzenwerts (Iₚ) ist größer als der Betrag eines Schwellenstromwerts (Iₜₕ), wobei der Betrag des Schwellenstromwerts (Iₜₕ) größer als der Betrag eines minimalen Schwellenstromwerts (I_{th, min}) ist, mit welchem ein Nullphasen-Widerstand (R_{zp}) mit einer vorgegebenen maximalen Abweichung vom tatsächlichen Innenwiderstand (Rᵢ) berechnet werden kann,
IV. der gefilterter Spannungswert (U_{filt}) zum zuvor ermittelten Zeitpunkt (tₚ) ist ein Spannungsspitzenwert (Uₚ),
V. der Stromspitzenwert (Iₚ) und der Spannungsspitzenwert (Uₚ) haben das gleiche Vorzeichen,
wobei diese Berechnungsvoraussetzungen nacheinander geprüft werden, jedoch die Berechnungsvoraussetzung I auch an einer beliebigen anderen Stelle im Verfahrensschritt c geprüft werden kann und wobei das Verfahren beendet wird, falls eine der Berechnungsvoraussetzungen nicht erfüllt ist,
d. Berechnen des Nullphasen-Widerstand (R_{zp}) aus dem Spannungsspitzenwert (Uₚ) und dem Stromspitzenwert (Iₚ), falls das Verfahren zuvor noch nicht beendet wurde,
e. Bereitstellen des Nullphasenwiderstands (R_{zp}) als zu bestimmender Innenwiderstand (Rᵢ) des elektrischen Energiespeichers, falls das Verfahren zuvor noch nicht beendet wurde.

2. Verfahren nach Anspruch 1, **gekennzeichnet durch** einen weiteren Verfahrensschritt:
f. Überprüfen der Gültigkeit der digitalen Spannungswerte (U) und der digitalen Stromwerte (I), wobei die digitalen Spannungswert (U) und die digitalen Stromwerte (I) als gültig gelten, falls der Verfahrensschritt a erfolgreich durchgeführt wurde, und Beenden des Verfahrens bei einem ungültigen digitalen Spannungswert (U) oder einem ungültigen digitalen Stromwert (I),
wobei der Verfahrensschritt f nach dem Verfahrensschritt a und vor dem Verfahrensschritt e abläuft.

3. Verfahren nach einem der Ansprüche 1 oder 2, **dadurch gekennzeichnet, dass** der Stromspitzenwert (Iₚ) und/oder der Spannungsspitzenwert (Uₚ) mittels eines, insbesondere drei-elementigen, FIFO-Prinzips ermittelt werden.

4. Verfahren nach einem der vorherigen Ansprüche, **gekennzeichnet durch** einen weiteren Verfahrensschritt:
g. Prüfen der Plausibilität des berechneten Nullphasen-Widerstands (R_{zp}), wobei dieser als plausibel gilt, falls er zwischen einem theoretischen Minimal-Grenzwert (R_{i,min}) und einem theoretischen Maximal-Grenzwert (R_{i,max}) liegt und Beenden des Verfahrens bei einem unplausiblen Nullphasen-Widerstand (R_{zp}),
wobei der Verfahrensschritt g zwischen dem Verfahrensschritt d und dem Verfahrensschritt e abläuft.

5. Verfahren nach einem der Ansprüche 1 bis 4, **dadurch gekennzeichnet, dass** das Berechnen des Nullphasenwiderstands (R_{zp}) im Verfahrensschritt d durch Bildung eines Quotienten aus Spannungsspitzenwert (Uₚ) und Stromspitzenwert (Iₚ) erfolgt.

6. Verfahren nach Anspruch 5, **gekennzeichnet durch** einen weiteren Verfahrensschritt:
h. Tiefpassfiltern des berechneten Nullphasen-Widerstands (R_{zp}), insbesondere mittels eines PT1-Glieds,
wobei der Verfahrensschritt h zwischen dem Verfahrensschritt d und dem Verfahrensschritt e abläuft.

7. Verfahren nach einem der Ansprüche 1 bis 4, **dadurch gekennzeichnet, dass** das Berechnen des Nullphasenwiderstands (R_{zp}) im Verfahrensschritt d durch Bildung eines Quotienten aus einem quadratischen Mittel der Spannungsspitzenwerte (Uₚ) und einem quadratischen Mittel der Stromspitzenwerte (Iₚ) erfolgt.

## Claims

1. Method for determining an internal resistance (Rᵢ) of an electrical energy store having the following method steps taking place in succession:
a. analogue-to-digital conversion of an analogue voltage signal (U_{analogue}) and of an analogue current signal (I_{analogue}) of the electrical energy store in order to obtain digital voltage values (U) and digital current values (I),
b. filtering of the digital voltage values (U) and of the digital current values (I) using a bandpass filter around the zero phase frequency (f_{zp}) in order to obtain filtered voltage values (U_{filt}) and current values (I_{filt}),
c. checking of whether the following calculation prerequisites are satisfied:
I. the bandpass filter is initialized,
II. a current peak value (Iₚ) with its associated time (tₚ) is ascertained from the filtered current values (I_{filt}),
III. the absolute value of the current peak value (Iₚ) is greater than the absolute value of a threshold current value (Iₜₕ), wherein the absolute value of the threshold current value (Iₜₕ) is greater than the absolute value of a minimum threshold current value (I_{th,min}) that can be used to calculate a zero phase resistance (R_{zp}) having a prescribed maximum difference from the actual internal resistance (Ri),
IV. the filtered voltage value (U_{filt}) at the previously ascertained time (tₚ) is a voltage peak value (Uₚ),
V. the current peak value (Iₚ) and the voltage peak value (Uₚ) have the same arithmetic sign,
these calculation prerequisites being checked in succession, but calculation prerequisite I also being able to be checked at any other point in method step c and the method being terminated if one of the calculation prerequisites is not satisfied,
d. calculation of the zero phase resistance (R_{zp}) from the voltage peak value (Uₚ) and the current peak value (Iₚ) if the method has not yet been terminated beforehand,
e. provision of the zero phase resistance (R_{zp}) as a determinable internal resistance (Rᵢ) of the electrical energy store if the method has not yet been terminated beforehand.

2. Method according to Claim 1, **characterized by** a further method step of:
f. verification of the validity of the digital voltage values (U) and of the digital current values (I), wherein the digital voltage values (U) and the digital current values (I) are deemed valid if method step a has been performed successfully, and termination of the method in the event of an invalid digital voltage value (U) or an invalid digital current value (I),
method step f taking place after method step a and before method step e.

3. Method according to either of Claims 1 and 2, **characterized in that** the current peak value (Iₚ) and/or the voltage peak value (Uₚ) are ascertained by means of an, in particular three-element, FIFO principle.

4. Method according to one of the preceding claims, **characterized by** a further method step of:
g. checking of the plausibility of the calculated zero phase resistance (R_{zp}), wherein the latter is deemed plausible if it is between a theoretical minimum limit value (R_{i,min}) and a theoretical maximum limit value (R_{i,max}) , and termination of the method in the event of an implausible zero phase resistance (R_{zp}),
method step g taking place between method step d and method step e.

5. Method according to one of Claims 1 to 4, **characterized in that** the calculation of the zero phase resistance (R_{zp}) in method step d is effected by forming a quotient from voltage peak value (Uₚ) and the current peak value (Iₚ).

6. Method according to Claim 5, **characterized by** a further method step of:
h. low-pass filtering of the calculated zero phase resistance (R_{zp}), in particular by means of a PT1 element,
method step h taking place between method step d and method step e.

7. Method according to one of Claims 1 to 4, **characterized in that** the calculation of the zero phase resistance (R_{zp}) in method step d is effected by forming a quotient from a root mean square of the voltage peak values (Uₚ) and a root mean square of the current peak values (Iₚ).

## Revendications

1. Procédé, destiné à déterminer une résistance interne (Rᵢ) d'un accumulateur d'énergie électrique comportant les étapes de procédé suivantes, à déroulement successif :
a. la conversion analogique/numérique d'un signal de tension analogique (U_{analog}) et d'un signal de courant analogique (I_{analog}) de l'accumulateur d'énergie électrique, pour obtenir des valeurs de tension numérique (U) et des valeurs de courant numérique (I),
b. le filtrage des valeurs de tension numérique (U) et des valeurs de courant numérique (I) à l'aide d'un filtre passe-bande, autour de la fréquence à phase zéro (f_{zp}) pour obtenir des valeurs de tension (U_{filt}) et valeurs de courant (I_{filt}) filtrées,
c. la vérification, si les conditions de calculs suivantes sont satisfaites :
I. le filtre passe-bande est initialisé,
II. une valeur de courant de crête (Iₚ) avec son moment correspondant (tₚ) est déterminée à partir des valeurs de courant (I_{filt}) filtrées,
III. le montant de la valeur de courant de crête (Iₚ) est supérieur au montant d'une valeur de courant seuil (Iₜₕ), le montant de la valeur de courant seuil (Iₜₕ) étant supérieur au montant d'une valeur minimale de courant seuil (I_{th, min}) à l'aide de laquelle une résistance en phase zéro (R_{zp}) peut être calculée avec un écart maximal prédéfini de la résistance interne (Rᵢ) effective,
IV. la valeur de tension (U_{filt}) filtrée au moment (tₚ) précédemment déterminé est une valeur de tension de crête (Uₚ),
V. la valeur de courant de crête (Iₚ) et la valeur de tension de crête (Uₚ) sont précédées du même signe,
ces conditions préalables de calcul étant vérifiées successivement, la condition préalable de calcul I pouvant toutefois aussi être vérifiée à une quelconque autre place dans l'étape de procédé c et le procédé s'achevant si l'une des conditions préalables de calcul n'est pas satisfaite,
d. le calcul de la résistance en phase zéro (R_{zp}) , à partir de la valeur de tension de crête (Uₚ) et de la valeur de courant de crête (Iₚ), si le procédé n'a pas encore été achevé précédemment,
e. la mise à disposition de la résistance en phase zéro (R_{zp}) comme étant la résistance interne (Rᵢ) à déterminer de l'accumulateur d'énergie électrique, si le procédé n'a pas encore été achevé précédemment.

2. Procédé selon la revendication 1, **caractérisé par** une étape de procédé supplémentaire :
f. la vérification de la validité des valeurs de tension numérique (U) et des valeurs de courant numérique (I), les valeurs de tension numérique (U) et les valeurs de courant numérique (I) étant réputées valables si l'étape de procédé a a été réalisée avec succès, et l'achèvement du procédé dans le cas d'une valeur de tension numérique (U) non valable ou d'une valeur de courant numérique (I) non valable,
l'étape de procédé f se déroulant après l'étape de procédé a et avant l'étape de procédé e.

3. Procédé selon l'une quelconque des revendications 1 ou 2, **caractérisé en ce que** la valeur de courant de crête (Iₚ) et/ou la valeur de tension de crête (Uₚ) sont déterminées au moyen d'un principe FIFO, notamment à trois éléments.

4. Procédé selon l'une quelconque des revendications précédentes, **caractérisé par** une étape de procédé supplémentaire :
g. la vérification de la plausibilité de la résistance en phase zéro (R_{zp}) calculée, celle-ci étant réputée plausible si elle se situe entre une valeur limite minimale (R_{i,min}) théorique et une valeur limite maximale (R_{i,max}) théorique, et l'achèvement du procédé si la résistance en phase zéro (R_{zp}) n'est pas plausible,
l'étape de procédé g se déroulant entre l'étape de procédé d et l'étape de procédé e.

5. Procédé selon l'une quelconque des revendications 1 à 4, **caractérisé en ce que** le calcul de la résistance en phase zéro (R_{zp}) dans l'étape de procédé d s'effectue par la formation d'un quotient à partir, de la valeur de tension de crête (Uₚ) et de la valeur de courant de crête (Iₚ).

6. Procédé selon la revendication 5, **caractérisé par** une étape de procédé supplémentaire :
h. le filtrage passe-bas de la résistance en phase zéro (R_{zp}) calculée, notamment au moyen d'un organe PT1,
l'étape de procédé h se déroulant entre l'étape de procédé d et l'étape de procédé e.

7. Procédé selon l'une quelconque des revendications 1 à 4, **caractérisé en ce que** le calcul de la résistance en phase zéro (R_{zp}) dans l'étape de procédé d s'effectue par formation d'un quotient d'une moyenne quadratique des valeurs de tension de crête (Uₚ) et d'une moyenne quadratique des valeurs de courant de crêtes (Iₚ).
